# EUROPÄISCHE PATENTSCHRIFT

(11) **EP 1 334 222 B1**
(45) Veröffentlichungstag und Bekanntmachung des Hinweises auf die Patenterteilung: **19.05.2004**
(21) Anmeldenummer: 01993719.2
(22) Anmeldetag: 18.10.2001
(51) Int. Cl.: C30B 25/08, C30B 25/10

(54) **CVD-REAKTOR MIT GRAPHITSCHAUM-ISOLIERTEM, ROHRFÖRMIGEM SUSZEPTOR**
CVD REACTOR WITH GRAPHITE-FOAM INSULATED, TUBULAR SUSCEPTOR
REACTEUR DE DEPOT CHIMIQUE EN PHASE VAPEUR AVEC SUSCEPTEUR TUBULAIRE ISOLE PAR MOUSSE DE GRAPHITE

(30) Priorität: 07.11.2000 DE 10055033
(43) Veröffentlichungstag der Anmeldung: 13.08.2003
(73) Patentinhaber: Aixtron AG, 52072 Aachen (DE)
(72) Erfinder: KÄPPELER, Johannes, 52146 Würselen (DE); WISCHMEYER, Frank, 57072 Aachen (DE); BERGE, Rune c/o Epigress AB, S-22370 Lund (SE)
(74) Vertreter: Grundmann, Dirk, Dr.
(86) Internationale Anmeldenummer: PCT/EP2001/012067
(87) Internationale Veröffentlichungsnummer: WO 2002/038838

(56) Entgegenhaltungen:
- EP-A- 0 746 009
- WO-A-90/13687
- WO-A-99/43874
- US-A- 4 512 391
- US-A- 5 879 462

## Beschreibung

Die Erfindung betrifft eine Vorrichtung zum Abscheiden insbesondere kristalliner Schichten auf insbesondere kristallinen Substraten mittels in eine geheizte Prozesskammer eingeleiteter Reaktionsgase, wobei die Prozesskammer die Höhlung eines insbesondere mehrteiligen Grafitrohres ist, welches in einem insbesondere Quarzwände aufweisenden Reaktorgehäuse angeordnet ist, welches Reaktorgehäuse im Bereich der Prozesskammer von einer Hochfrequenz-Spule umgeben ist, wobei der Raum zwischen Reaktorgehäusewand und Grafitrohr von einer Grafitschaum-Manschette ausgefüllt ist.

Eine deratige Vorrichtung ist beispielsweise aus der US 5,879,462 A bekannt. Diese Schrift beschreibt einen Reaktor, dessen Gehäusewand von einem Quarzrohr gebildet ist, um welches eine HF-Spule angeordnet ist. In dem Bereich, in dem die HF-Spule das Quarzrohr umgibt, liegt innerhalb des Quarzrohres ein aus Grafit gefertigtes Rohr, welches den Suszeptor bildet. Dieses Grafit-Rohr ist ummantelt von einer Manschette, die aus einem Grafitschaum besteht. Die Manschette hat eine geringere Wärmeleitfähigkeit als das Grafitrohr. Das Grafitrohr wird durch von dem HF-Feld erzeugte Wirbelströme aufgeheizt. Die Grafitschaum-Manschette dient zu Wärmeisolierung.

Der Erfindung liegt die Aufgabe zugrunde, die Wärmeisolierung zu verbessern.

Gelöst wird die Aufgabe durch die in den Ansprüchen angegebene Erfindung.

Der Anspruch 1 sieht zunächst und im Besonderen vor, dass die Grafitschaum-Manschette durchgehend, in Längsrichtung geschlitzt ist, wobei die Weite des Schlitzes größer ist, als die maximale beim Aufheizen auf die Prozesstemperatur zu erwartende Längenausdehnung der Grafitschaum-Manschette in Umfangsrichtung. Die erfindungsgemäße Vorrichtung dient insbesondere zum Abscheiden von Sie-Schichten und kann auch für die Sublimation oder das Ausheilen von SiC-Schichten genutzt werden. Dort liegen die Prozesstemperaturen über 1600°C. Zufolge der geschlitzten Grafitschaum-Manschette ist dort die Induktion von Wirbelströmen in erheblichen Maße reduziert. Da der Schlitz sich auch bei den Prozesstemperaturen nicht schließt, ist eine parasitäre Aufheizung der der Wärmeisolation dienende Grafitschaum-Manschette auch bei den Prozesstemperaturen weitestgehend unterbunden. Der in der Grafitschaum-Wandung vorgesehen Längsschlitz erlaubt darüber hinaus eine geringfügige Ausdehnung der Grafitschaum-Manschette in Umfangsrichtung. In einer bevorzugten Ausgestaltung der Erfindung verläuft der Längsschlitz im Wesentlichen parallel zur Achse der Grafitschaum-Manschette. Die Richtung des Schlitzes in Radialrichtung verläuft dabei aber nicht geradlinig, so dass keine direkte Strahlung von der Außenwandung des Grafitrohres durch den Schlitz gelangen kann. Bevorzugt besitzt der Schlitz eine V-Form. In einer Weiterbildung der Erfindung ist vorgesehen, dass die Innenwandung der Grafit-Manschette, welche unmittelbar dem Schlitz benachbart ist, einen Spaltabstand zur Außenwandung des Grafitrohres hat. Auch dieser Spaltabstand ist größer, als die maximale, beim Aufheizen auf die Prozesstemperatur zu erwartende Ausdehnung von Grafitschaum-Manschette und Grafitrohr. Dieser Spalt bleibt demzufolge auch im heißen Zustand erhalten. Es bilden sich hier keine temporären Wärmebrücken zwischen dem Grafitrohr und der Grafitschawn-Manschette. Hierdurch werden Spannungsüberschläge und Lichtbögen zwischen Grafitrohr und Grafitschaum-Manschette unterbunden, die zu lokalen Wärmequellen und einer Materialermüdung führen können. In einer bevorzugten Ausgestaltung besitzt das Grafitrohr einen im Wesentlichen rechteckigen Querschnitt, wobei drei Außenwandungen dieses rechteckigen Grafitrohres mit Spaltabstand zur Manschetteninnenwandung liegen. Der Schlitz kann dabei derjenigen Manschetteninnenwandung gegenüberliegen, die in Berührungskontakt mit dem Grafitrohr steht. Die Spaltweite bzw. die Schlitzweite kann zwischen 0,5 und 1 mm betragen.

Ein Ausführungsbeispiel der Erfindung wird nachfolgend anhand beigefügter Zeichnungen erläutert. Es zeigen:
- Fig. 1: ein Ausführungsbeispiel der Erfindung in perspektivischer Darstellung teilweise aufgebrochen im Schnitt und
- Fig. 2: einen Schnitt gemäß der Linie II-II in Fig. 1.

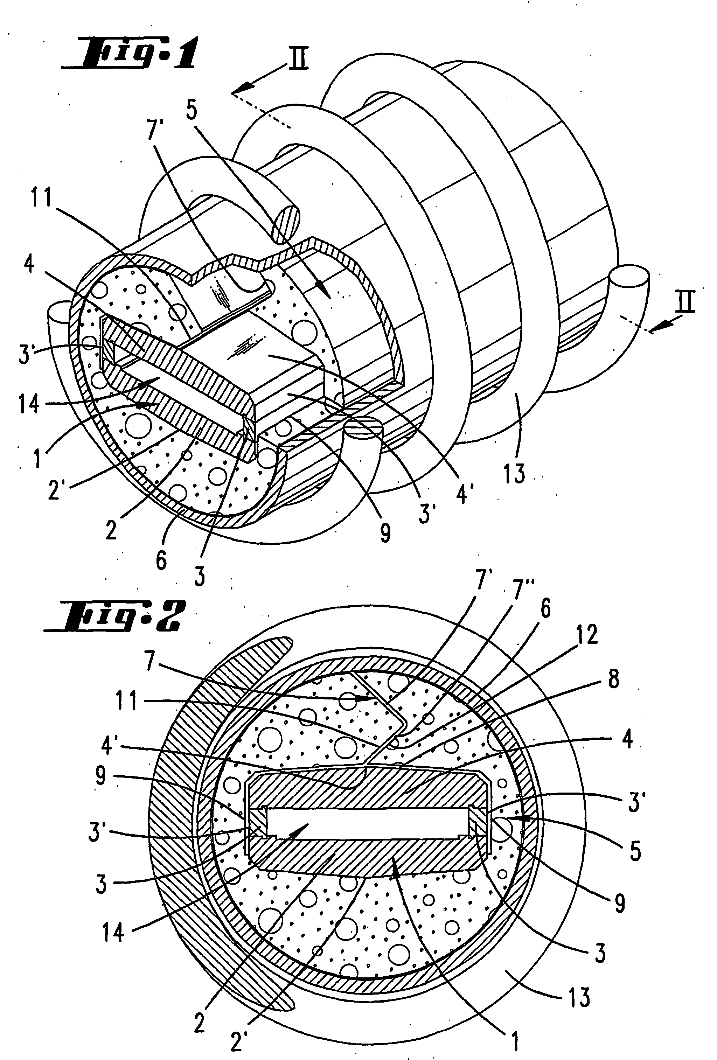

Der CVD-Reaktor besitz ein Quarzrohr 6, welches die Reaktorwand bildet. Innerhalb des Quarzrohres befindet sich etwa in dessen Zentrum und sich in Richtung der Achse des kreiszylinderförmigen Quarzrohres 6 erstrekkend ein Grafitrohr 1, welches den Suszeptor bildet.
Das Grafitrohr 1 besteht im Ausführungsbeispiel aus insgesamt vier Teilen, einem Boden 2, welcher mit seiner nach außen gewölbten Außenwandung 2' in berührender Anlage an einem Innenwandabschnitt einer Grafitschaum-Manschette 5 anliegt. Gegenüberliegend zum Boden 2 besitz das Grafitrohr 1 eine Decke 4, welche mittels zwei Seiten 3 von der Decke beabstandet gehalten ist.

Auch die Außenwandung der Decke 4 ist nach außen hin gewölbt.

Die Höhlung, die von dem Boden 2, den Seiten 3 und der Decke 4 gebildet ist, ist die Prozesskammer 14.

Das Grafitrohr 1 ist von der Reaktorwand 6 beabstandet. Der Abstandsraum wird von einer Grafitschaum-Manschette 5 ausgefüllt. Die Grafitschaum-Manschette 5 besitzt eine zentrale Höhlung, die im Wesentlichen die Form der Außenumrisskontur des Grafitrohres 1 besitzt. Diese Höhlung ist allerdings größer, so dass nur der Boden mit seiner Außenwandung 2' in berührender Anlage an der Innenwandung der Höhlung der Grafitschaum-Manschette 5 anliegt. Die Seitenwände 3' liegen mit einem Spaltabstand zu der entsprechenden Innenwandseite 9 der Grafitschaum-Manschettenhöhlung. Auch die von der Bodenaußenwand 2' weg gerichtete Deckenwand 4' der Decke 4 liegt mit Abstand zu der ihr gegenüberliegenden Deckeninnenwand 8 der Höhlung.

Etwa in der Mitte der zur Decke 4 gerichteten Innenwand 8 beginnt ein V-förmiger Schlitz, welcher sich durch die gesamte Grafitschaum-Manschette 5 bis zum Quarzrohr 6 erstreckt. In Längserstreckungsrichtung (Achsrichtung) des Grafitrohres 1 bzw. des Quarzrohres 6 verläuft der Schlitz 7 gradlinig. In Radialrichtung, also in Richtung vom Suszeptor 1 in Richtung Reaktorwand 6 verläuft der Schlitz 7 dagegen ungradlinig. Er bildet zwei Schlitzabschnitte 7', 7'' aus, welche in einem Winkel zueinander verlaufen, so dass Strahlung, die von der Deckenaußenwandung 4' abgestrahlt wird, nicht unmittelbar bis zum Quarzrohr 6 dringt.

Die beiden aufeinander zu gerichteten Schlitzwände 11, 12 haben einen Abstand voneinander, der so groß ist, dass sich die Schlitzwände 11, 12 auch bei der Prozesstemperatur von mehr als 1600°C nicht berühren. Die Schlitzweite beträgt etwa 0,5 bis 1 mm. Die gleiche Weite besitzt der Spalt zwischen der Graftirohraußenwandung und der Grafitschaum-Manschetteninnenwandung.

Der der Decke 4 zugeordnete Spalt kann etwas schmaler (1,5 mm) sein, als der den Seiten 4 zugeordnete Spalt (2 mm).

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden insbesondere kristalliner Schichten auf insbesondere kristallinen Substraten mittels in eine auf eine Prozesstemperatur geheizte Prozesskammer (14) eingeleiteter Reaktionsgase, wobei die Prozesskammer (14) die Höhlung eines insbesondere mehrteiligen Grafitrohres (1) ist, welches in einem insbesondere Quarzwände aufweisenden Reaktorgehäuse angeordnet ist, welches Reaktorgehäuse im Bereich der Prozesskammer (14) von einer Hochfrequenz-Spule (13) umgeben ist, wobei der Raum zwischen der Reaktorgehäusewand (6) und dem Grafitrohr (1) von einer Grafitschaum-Manschette (5) ausgefüllt ist, **dadurch gekennzeichnet, dass** die Grafitschaum-Manschette (5) in Längs- und Radialrichtung verlaufend durchgehend geschlitzt ist, wobei die Weite des Schlitzes (7) größer ist, als die maximale, beim Aufheizen auf die Prozesstenperatur zu erwartende Ausdehnung der Grafitschaum-Manschette (5) in Umfangsrichtung.

2. Vorrichtung nach Anspruch 1, **dadurch gekennzeichnet, dass** der im Wesentlichen parallel zur Längserstreckung (Achsrichtung) der Grafitschaum-Manschette (5) verlaufende Schlitz (7) in Radialrichtung ungradlinig verläuft.

3. Vorrichtung nach Anspruch 2, **dadurch gekennzeichnet, dass** der Schlitz (7) ein V-Profilform besitzt.

4. Vorrichtung nach einem der vorhergehenden Ansprüche, **dadurch gekennzeichnet, dass** über die gesamte Schlitzlänge der dem Schlitz (7) benachbarte Manschetten-Innenwandabschnitt (8) einen Spaltabstand zur Außenwandung (4') des Grafitrohres (5) hat, welcher größer ist, als die maximale, beim Aufheizen auf die Prozesstemperatur zu erwartende Ausdehnung der Grafitschaum-Manschette (5) und des Grafitrohres (1).

5. Vorrichtung nach einem der vorhergehenden Ansprüche, **dadurch gekennzeichnet, dass** das Grafitrohr einem im Wesentlichen rechteckigen Querschnitt hat und drei Außenwandungen (3', 4') mit Spaltabstand zur Manschetteninnenwandung (8, 9) liegen.

6. Vorrichtung nach einem der vorhergehenden Ansprüche, **dadurch gekennzeichnet, dass** der Schlitz (7) etwa in der Mitte der der in Berührungskontakte mit der Man-Schotte (5) stehenden Grafitrohrwand (2') gegenüberliegenden Grafitschaum-Manschettenwand (8) angeordnet ist.

7. Vorrichtung nach einem der vorhergehenden Ansprüche, **dadurch gekennzeichnet, dass** die Schlitzweite und/oder die Spaltweite zwischen 0,5 und 1 mm beträgt.

## Claims

1. Device for depositing in particular crystalline layers on in particular crystalline substrates by means of reaction gases which are introduced into a process chamber (14) which has been heated to a process temperature, the process chamber (14) being the cavity in an in particular multipart graphite tube (1) which is disposed in a reactor housing which in particular has quartz walls and which is surrounded by a highfrequency coil (13) in the region of the process chamber (14), the space between the reactor housing wall (6) and the graphite tube (1) being filled by a graphite foam sleeve (5), **characterized in that** the graphite foam sleeve (5) has a continuous slit running in the longitudinal and radial directions, the width of the slit (7) being greater than the maximum expansion of the graphite foam sleeve (5) in the circumferential direction which is to be expected during heating to the process temperature.

2. Device according to Claim 1, **characterized in that** the slit (7), which runs substantially parallel to the longitudinal extent (axial direction) of the graphite foam sleeve (5), does not run in a straight line in the radial direction.

3. Device according to Claim 2, **characterized in that** the slit (7) has a V-shaped profile.

4. Device according to one of the preceding claims, **characterized in that**, over the entire slit length, the sleeve inner wall section (8) adjacent to the slit (7) is at a gap spacing from the outer wall (4') of the graphite tube (5) which is greater than the maximum expansion of the graphite foam sleeve (5) and of the graphite tube (1) which is to be expected during heating to the process temperature.

5. Device according to one of the preceding claims, **characterized in that** the graphite tube has a substantially rectangular cross section, and three outer walls (3', 4') lie at a gap spacing from the sleeve inner wall (8, 9).

6. Device according to one of the preceding claims, **characterized in that** the slit (7) is disposed approximately in the center of the graphite foam sleeve wall (8) which is on the opposite side from the graphite tube wall (2') which is in physical contact with the sleeve (5).

7. Device according to one of the preceding claims, **characterized in that** the slit width and/or the gap width is between 0.5 and 1 mm.

## Revendications

1. Dispositif servant à déposer en particulier des couches cristallines, en particulier sur des supports cristallins, au moyen de gaz réactionnels introduits dans une chambre opératoire (14) chauffée à la température opératoire, cette chambre de processus (14) étant constituée par la cavité d'un tube en graphite (1), en particulier un tube en plusieurs parties, qui est placé dans une enceinte de réacteur, en particulier une enceinte dont les parois sont en quartz, et cette enceinte de réacteur étant entourée, au voisinage de la chambre opératoire (14), d'une bobine haute fréquence (13), et l'espace compris entre la paroi (6) de l'enceinte de réacteur et le tube en graphite (1) étant rempli par une gaine (5) en mousse de graphite, **caractérisé en ce que** la gaine (5) en mousse de graphite est entièrement fendue longitudinalement et transversalement dans toute l'épaisseur, la largeur de la fente (7) étant supérieure à la dilatation maximale de la gaine (5) en mousse de graphite, dans la direction périphérique, à laquelle il faut s'attendre quand on porte sa température à la température opératoire.

2. Dispositif selon la première revendication 1, **caractérisé en ce que** la fente (7) sensiblement parallèle à l'extension longitudinale (dans la direction axiale) de la gaine (5) en mousse de graphite n'est pas rectiligne dans la direction transversale.

3. Dispositif selon la revendication 2, **caractérisé en ce que** la fente (7) a la forme d'un profilé en V.

4. Dispositif selon l'une quelconque des revendications précédentes, **caractérisé en ce que**, sur toute la longueur de la fente, la partie (8) de la paroi intérieure de la gaine qui est proche de la fente (7) est séparée de la paroi extérieure (4') du tube de graphite (1) par un interstice qui est plus grand que la dilatation maximale de la gaine (5) en mousse de graphite et du tube de graphite (1) à laquelle il faut s'attendre lorsqu'on porte la température à la température opératoire.

5. Dispositif selon l'une quelconque des revendications précédentes, **caractérisé en ce que** le tube de graphite présente une section sensiblement rectangulaire et **en ce que** trois parois extérieures (3', 4') sont séparées de la paroi intérieure (8, 9) de la gaine par un interstice.

6. Dispositif selon l'une quelconque des revendications précédentes, **caractérisé en ce que** la fente (7) se trouve à peu près au milieu de la paroi (8) de la gaine en mousse de graphite située en face de la paroi (2') du tube de graphite qui est en contact avec la gaine (5).

7. Dispositif selon l'une quelconque des revendications précédentes, **caractérisé en ce que** la largeur de la fente ou de l'interstice, ou des deux, est comprise entre 0,5 et 1 mm.
